(19) Europäisches Patentamt
European Patent Office
Office européen des brevets

(11) **EP 3 023 396 A1**

(12) **EUROPEAN PATENT APPLICATION**
published in accordance with Art. 153(4) EPC

(43) Date of publication:
**25.05.2016 Bulletin 2016/21**

(51) Int Cl.:
**C03C 4/12** *(2006.01)*  **C03C 3/32** *(2006.01)*
**H01L 33/50** *(2010.01)*

(21) Application number: **14826143.1**

(22) Date of filing: **02.07.2014**

(86) International application number:
**PCT/JP2014/067606**

(87) International publication number:
**WO 2015/008621 (22.01.2015 Gazette 2015/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.07.2013 JP 2013151051**

(71) Applicant: **Central Glass Company, Limited Yamaguchi 755-0001 (JP)**

(72) Inventors:
• **OKAMOTO, Hideyuki**
  **Matsusaka-shi**
  **Mie 515-0001 (JP)**

**Description**

Field of the Invention

The present invention relates to a fluoride glass material capable of encapsulating therein a luminescent substance without causing deactivation of the luminescent substance.

Background Art

White LED devices have recently been put into use as illumination light sources in place of filament lamps. Many of currently available white LED devices realize pseudo white light by combination of YAG-Ce yellow oxide phosphors and GaN blue LED elements.

However, the conventional combination of YAG-Ce phosphors and blue LED elements faces the problem that cyan component light (wavelength: up to 500 nm) and red component light (wavelength: 600 nm) are not sufficient. It is thus common practice to supplement these insufficient component lights by mixing a plurality of phosphors. For example, Patent Document 1 discloses a high-color-rendering white light source using a YAG-Ce phosphor in combination of a red-emitting Eu complex.

Further, nitride phosphors have recently been proposed as high-efficiency red phosphors. For example, Non-Patent Document 1 discloses Eu-doped $CaAlSiN_3$ phosphor particles prepared by sintering a raw material at 1600 to 2000°C in a high-pressure atmosphere of nitrogen (up to 10 atm) so as to avoid evaporation of constituent components during the sintering.

In general, a phosphor is mounted, in the form of being mixed in a resin encapsulant, on an LED element for use in illumination. There are however problems such as degradation of the resin by an ultraviolet light from phosphor excitation light source, inhibition of operation of the LED element by penetration of water in the resin during long-term use etc. (see, for example, Patent Document 2). It is thus proposed to use a low-melting oxide glass, which has higher durability and higher water barrier function than those of the resin, as a phosphor encapsulant as disclosed in Patent Document 2.

The use of such a glass encapsulant allows achievement of a high-weather-resistant LED device as discussed in Patent Document 2. In the case of using the glass as the phosphor encapsulant, on the other hand, it becomes necessary to consider the possibility of degradation of the phosphor by heat because of the need to heat a mixture of the phosphor and the glass up to a temperature higher than or equal to a softening temperature of the glass. For this reason, low-melting glasses such as $Sb_2O_3$-$B_2O_3$ glass, $Bi_2O_3$-$GeO_2$ glass, $ZnO$-$B_2O_3$ glass, $CaO$-$B_2O_3$ glass, $CaO$-$P_2O_5$ glass and fluoride glass are generally used as phosphor encapsulants (see, for example, Patent Documents 3 and 4).

In the case of using the low-melting glass as the phosphor encapsulant, it is conceivable to add particles of the phosphor into a melt of the glass. In this case, however, there is a possibility that the phosphor precipitates due to a difference in specific gravity between the phosphor and the glass melt. It is thus proposed to pulverize the glass into a powder, mix the glass powder with particles of the phosphor and sinter the resulting glass powder mixture (see, for example, Patent Document 5).

Prior Art Documents

Patent Documents

Patent Document 1: Japanese Patent No. 5045432
Patent Document 2: Japanese Laid-Open Patent Publication No. 2008-19109
Patent Document 3: Japanese Laid-Open Patent Publication No. 2012-178395
Patent Document 4: Japanese Patent No. 4492378
Patent Document 5: Japanese Laid-Open Patent Publication No. 2010-280797
Patent Document 6: Japanese Laid-Open Patent Publication No. 2006-248800

Non-Patent Documents

Non-Patent Document 1: Yeh CW et al., "Origin of thermal degradation of Sr(2-x)Si5N8:Eu(x) phosphors in air for light-emitting diodes", J. Am. Chem. Soc., 134, 14108-14117 (2012)

Summary of the Invention

Problems to be Solved by the Invention

In recent years, various attempts are made to ensure long lifetime and high color-rendering properties of LED devices. As mentioned above, it is proposed to mix the phosphor particles in the glass encapsulant, rather than mix the phosphor particles in the resin encapsulant as in conventional techniques, for improvement of device lifetime.

However, there is a report on the deactivation of a nitride phosphor by heating in the presence of oxygen (see Non-Patent Document 1). Non-Patent Document 1 teaches that, when a $Sr_{2-x}Si_5N_8:Eu^{2+}$ phosphor is heated in the presence of oxygen, a divalent Eu cation of the phosphor is reduced to a trivalent state. It means that, depending on the combination of the phosphor and the glass, the sintering of the glass may lead to a significant deterioration in the emission efficiency of the phosphor.

It is accordingly an object of the present invention to provide a glass material for use as an encapsulant, capable of encapsulating therein a phosphor while suppressing deactivation of the phosphor.

Means for Solving the Problems

The present inventors have found that the mixing of a nitride phosphor in an oxide glass, which contains oxygen in its composition, results in significant deactivation of the nitride phosphor. As a result of researches made based on such a finding, the present inventors have found that a fluoride glass material of specific composition is capable of suppressing deactivation of a nitride phosphor by producing a phosphor-dispersed glass in a low-oxygen-concentration atmosphere. The present inventors have also found as a result of further researches that the above specific fluoride glass material is capable of suppressing deactivation of the phosphor regardless of the kind of the phosphor, e.g., regardless of whether the phosphor is either an oxide phosphor or a nitride phosphor.

Namely, there is provided according a first aspect of the present invention a phosphor-dispersed glass comprising: phosphor particles; and a phosphor encapsulant, wherein the phosphor encapsulant is a fluoride glass material containing 1 to 45 mol% of $AlF_3$, 30 to 60 mol% of a sum of a fluoride of Hf and a fluoride of Zr, 20 to 65 mol% of alkaline earth fluorides in total, 2 to 25 mol% in total of at least one fluoride of element selected from the group consisting of Y, La, Gd and Lu and 0 to 20 mol% in total of at least one fluoride of element selected from the group consisting of Na, Li and K.

There is provided according to a second aspect of the present invention a phosphor-dispersed glass comprising: phosphor particles; and a phosphor encapsulant, wherein the phosphor encapsulant is a fluoride glass material containing 20 to 45 mol% of $AlF_3$, 0 to 30 mol% of a sum of a fluoride of Hf and a fluoride of Zr, 35 to 65 mol% of alkaline earth fluorides in total, 2 to 25 mol% in total of at least one fluoride of element selected from the group consisting of Y, La, Gd and Lu and 0 to 9 mol% in total of at least one fluoride of element selected from the group consisting of Na, Li and K.

In the present specification, it is defined that the deactivation of the phosphor is suppressed when the rate of decrease of the emission efficiency of the phosphor after encapsulation in the glass material relative to the emission efficiency of the phosphor before encapsulation in the glass material is 30% or lower. The rate of decrease of the emission efficiency can be evaluated in term of a value of [{(internal quantum efficiency of phosphor particles before encapsulation in glass material) - (internal quantum efficiency of phosphor particles after encapsulation in glass material)}/(internal quantum efficiency of phosphor particles before encapsulation in glass matelial)]$\times$100 by measuring the internal quantum efficiency according to the after-mentioned method.

The term "phosphor encapsulant" refers to an encapsulant for encapsulating therein phosphor particles. In the present invention, the above-mentioned fluoride glass material serves as the phosphor encapsulant. In a state where the phosphor particles are dispersed in the phosphor encapsulant, the phosphor encapsulant is in contact with the phosphor particles. In such a contact state of the phosphor encapsulant and the phosphor particles, it is possible in the present invention to suppress deactivation of the phosphor particles even when the glass is heated in a temperature range equal to or higher by 100°C than a glass softening temperature. In order to uniformly disperse the phosphor particles in the phosphor encapsulant, the phosphor encapsulant is generally used in powder form at the time of mixing the phosphor encapsulant with the phosphor particles.

Further, the term "phosphor-dispersed glass" refers to a glass obtained by mixing phosphor particles in a phosphor encapsulant and sintering the resulting mixture. The phosphor-dispersed glass is in a state where the phosphor particles are dispersed in the phosphor encapsulant.

The phosphor-dispersed glass is produced in an atmosphere whose oxygen concentration is decreased to as low a level as possible in the present invention. There may occur deactivation of the phosphor particles or coloring of the glass material as the phosphor encapsulant when oxygen or moisture enters from ambient environment during e.g. pulverization of the glass material, mixing of the glass material powder and the phosphor particles or sintering of the glass powder mixture for production of the phosphor-dispersed glass.

There is thus provided according to a third aspect of the present invention a method for producing the phosphor-dispersed glass, comprising: mixing the phosphor particles with a powder of the above fluoride glass material and thereby forming a mixture; and sintering the mixture, wherein the sintering is performed in an atmosphere whose oxygen concentration is 5000 ppm or lower.

In the present invention, it is possible to provide the phosphor-dispersed glass capable of suppressing deactivation of the phosphor particles. It is further possible to utilize a red phosphor with high efficiency and obtain a high-color-rendering LED device since the deactivation of the nitride phosphor can be suppressed in the present invention.

Brief Description of the Drawings

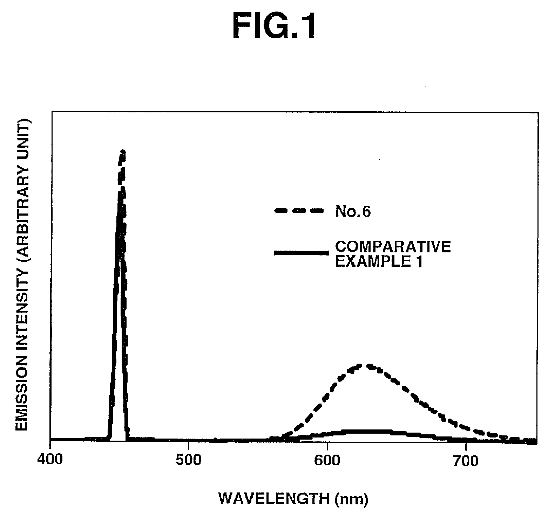

FIG. 1 is a diagram showing fluorescence spectra of sample No. 1 of Example 1 and Comparative Example 1.

Detailed Description of the Embodiments

It is considered that there will occur reaction of a fluoride glass with a phosphor under high-temperature conditions where the fluoride glass is meltable as the fluoride glass contains in its composition a fluorine ion ($F^-$) potentially high in reactivity. The fluoride glass is thus known as a relatively difficult-to-handle glass among various glass materials. On the other hand, a nitride phosphor is formed in a high-temperature high-pressure atmosphere of nitrogen as discussed above. It is thus known that the nitride phosphor is more likely to be deactivated than other phosphors such as oxide phosphor.

In view of the above common technical knowledge, the present invention has been made based on the findings by selecting the above specific fluoride glass material so as to suppress deactivation of the phosphor even when the phosphor is a nitride phosphor etc. which is likely to be deactivated. In the present invention, it is assumed that the phosphor-dispersed glass contains substantially no oxygen (O) in its glass composition as the phosphor-dispersed glass is produced in an atmosphere whose oxygen concentration is set as low as possible.

More specifically, a first embodiment of the present invention is a phosphor-dispersed glass comprising: phosphor particles; and a phosphor encapsulant, wherein the phosphor encapsulant is a fluoride glass material containing 1 to 45 mol% of $AlF_3$, 30 to 60 mol% of a sum of a fluoride of Hf and a fluoride of Zr, 20 to 65 mol% of alkaline earth fluorides in total, 2 to 25 mol% in total of at least one fluoride element selected from the group consisting of Y, La, Gd and Lu and 0 to 20 mol% in total of at least one fluoride of element selected from the group consisting of Na, Li and K.

The first embodiment is advantageous in that the fluoride glass material shows a softening temperature of 400°C or lower so as to suppress deactivation of the phosphor by heat. In the first embodiment, the softening temperature of the fluoride glass material is preferably 250 to 400°C. It is preferable that the softening temperature of the fluoride glass material is as low as possible. However, there is a tendency that the fluoride glass material deteriorates in water resistance as the softening temperature of the fluoride glass material becomes lowered. The softening temperature of the fluoride glass material is thus preferably set higher than or equal to 250°C.

Hereinafter, the fluoride glass composition of the first embodiment will be explained below.

As a glass forming component of the fluoride glass material, $AlF_3$ is contained in an amount of 1 to 45 mol%. When the amount of $AlF_3$ in the fluoride glass material is less than 1 mol%, the moisture resistance of the fluoride glass material tends to be insufficient. When the amount of $AlF_3$ in the fluoride glass material exceeds 45 mol%, the fluoride glass material tends to be difficult to vitrify. The upper limit of the $AlF_3$ content amount may preferably be set to 40 mol% or less.

The fluorides of Hf and Zr are used as a component to lower the softening temperature of the fluoride glass material and are contained in an amount of 30 to 60 mol% in total. The sum of the Hf and Zr fluorides may be of one kind or two or more kinds. Examples of these fluorides are $HfF_4$, $ZrF_4$ and the like. When the total amount of the Hf and Zr fluorides in the fluoride glass material exceeds 60 mol%, the water resistance and weather resistance of the fluoride glass material are significantly deteriorated so the fluoride glass material is not suitable as the phosphor encapsulant. The total content amount of the Hf and Zr fluorides is preferably in the range of 35 to 55 mol%.

The alkaline earth fluorides are used as a glass forming component of the fluoride glass material as in the case of $AlF_3$ and are contained in an amount of 20 to 65 mol% in total. The fluoride glass material may be difficult to vitrify when the total amount of the alkaline earth fluorides in the fluoride glass material is less than 20 mol% or exceeds 65 mol%.

At least one selected from the group consisting of $MgF_2$, $CaF_2$, $SrF_2$ and $BaF_2$ is usable as the alkaline earth fluorides. These fluorides can be used alone or in combination of two or more thereof. Preferably, the fluoride glass material has a $MgF_2$ content of 0 to 15 mol%, a $CaF_2$ content of 0 to 25 mol%, a $SrF_2$ content of 0 to 30 mol% and a $BaF_2$ content of 0 to 25 mol%. As the emission color of the glass may vary depending on the balance between the content amounts of the respective alkaline earth fluorides, the content amounts of the respective alkaline earth fluorides are set as appropriate so as to obtain a desired emission color.

The at least one fluoride of element selected from Y, La, Gd and Lu is contained, as a glass forming component of the fluoride glass material, in an amount of 2 to 25 mol% in total. As a fluoride glass is potentially difficult to vitrify, it is common practice to produce the fluoride glass by e.g. rapid cooling of glass melt. However, the fluoride glass material may not be obtained in suitable form by such operation when the total amount of the at least one fluoride of element selected from Y, La, Gd and Lu in the fluoride glass material is less than 2 mol% or exceeds 25 mol%. The total content amount of the at least one fluoride of element selected from Y, La, Gd and Lu is preferably in the range of 8 to 20 mol%.

The at least one fluoride of element selected from Na, Li and K is used as a component to increase the vitrification range of the fluoride glass material and is contained in an amount of 0 to 20 mol% in total so as to facilitate vitrification of the fluoride glass material. The water resistance and weather resistance of the fluoride glass material may be deteriorated when the total amount of the at least one fluoride of element selected from Na, Li and K in the fluoride glass material exceeds 20 mol%.

Further, a second embodiment of the present invention is a phosphor-dispersed glass comprising: phosphor particles; and a phosphor encapsulant, wherein the phosphor encapsulant is a fluoride glass material containing 20 to 45 mol% of $AlF_3$, 0 to 30 mol% of a sum of a fluoride of Hf and a fluoride of Zr, 35 to 65 mol% of alkaline earth fluorides in total, 2 to 25 mol% in total of at least one fluoride of element selected from the group consisting of Y, La, Gd and Lu and 0 to 9 mol% in total of at least one fluoride of element selected from the group consisting of Na, Li and K.

The second embodiment is advantageous in that the fluoride glass material attains good water resistance as tested by weather resistance test according to JIS 3254-1995 "Testing Method for Chemical Durabilities of Fluoride Glasses". In the second embodiment, the softening temperature of the fluoride glass material is preferably 380 to 500°C so as to combine good weather resistance with low softening temperature.

Hereinafter, the difference between the first and second embodiments will be mainly explained later.

In the second embodiment, $AlF_3$ is contained in an amount of 20 to 45 mol% in the fluoride glass material. The amount of $AlF_3$ in the fluoride glass material is preferably in the range of 30 to 40 mol%.

The fluorides of Hf and Zr are contained in an amount of 0 to 30 mol% in total in the second embodiment. The sum of the Hf and Zr fluorides may be of one kind or two or more kinds. Examples of these fluorides are $HfF_4$, $ZrF_4$ and the like. The fluoride glass material attains good water resistance and weather resistance when the total amount of the Hf and Zr fluorides in the fluoride glass material is 30 mol% or less. The upper limit of the Hf and Zr fluoride content amount may preferably be set to 10 mol%.

The lower limit of the Hf and Zr fluoride content amount may be set to 1 mol% or more as the softening temperature of the fluoride glass becomes lowered with the addition of the Hf and Zr fluorides.

The alkaline earth fluorides are contained in an amount of 35 to 65 mol% in total in the fluoride glass material. The fluoride glass material may be difficult to vitrify when the total amount of the alkaline earth fluorides in the fluoride glass material is less than 35 mol% or exceeds 65 mol%. The total content amount of the alkaline earth fluorides is preferably in the range of 42 to 55 mol%.

At least one selected from the group consisting of $MgF_2$, $CaF_2$, $SrF_2$ and $BaF_2$ is usable as the alkaline earth fluorides. These fluorides can be used alone or in combination of two or more thereof. Preferably, the fluoride glass material has a $MgF_2$ content of 0 to 15 mol%, a $CaF_2$ content of 0 to 25 mol%, a $SrF_2$ content of 0 to 30 mol% and a $BaF_2$ content of 0 to 25 mol%. It is preferable in the second embodiment to use two or more kinds of alkaline earth fluorides as the softening temperature of the fluoride glass can be prevented from increasing by the use of two or more kinds of alkaline earth fluorides. There is no particular limitation on the content amounts of the respective alkaline earth fluorides. The kinds of the alkaline earth fluorides used and the content amounts of the respective alkaline earth fluorides are preferably set as appropriate within the range of a $MgF_2$ content of 3 to 15 mol%, a $CaF_2$ content of 15 to 25 mol%, a $SrF_2$ content of 10 to 30 mol% and a $BaF_2$ content of 5 to 22 mol%. As long as two or more kinds of alkaline earth fluorides are used, it is feasible to use three kinds of alkaline earth fluorides or use four kinds of alkaline earth fluorides.

In the second embodiment, the at least one fluoride of element selected from Y, La, Gd and Lu is contained in an amount of 2 to 25 mol% in total. The total amount of the at least one fluoride of element selected from Y, La, Gd and Lu in the fluoride glass material is preferably in the range of 8 to 20 mol%.

The at least one fluoride of element selected from Na, Li and K is contained in an amount of 0 to 9 mol% in total in the second embodiment. The fluoride glass material improves in water resistance and weather resistance when the total amount of the at least one fluoride of element selected from Na, Li and K in the fluoride glass material is less than 9 mol%. The total amount of the at least one fluoride of element selected from Na, Li and K in the fluoride glass material is preferably in the range of 0 to 5 mol%.

In the phosphor-dispersed glass of the present invention, the total amount of $AlF_3$, $ZrF_4$, $HfF_4$, $BaF_2$, $SrF_2$, $CaF_2$, $MgF_2$, $YF_3$, $LaF_3$, $GdF_3$, $LuF_3$, NaF, LiF and KF in the fluoride glass material is preferably in the range of 80 to 100 mol%, more preferably 90 to 100 mol%, still more preferably 95 to 100 mol%. The sum of the above respective content amounts may be set to 100 mol%. It is feasible to add an arbitrary component within the range that does not impair the softening temperature and stability of the fluoride glass material. As such an arbitrary component, there can be used any of fluorides of Pb, Sn, Zn and the like.

Furthermore, the phosphor particles are preferably of at least one selected from the group consisting of nitrides, sulfides, selenium compounds, tellurium compounds, chlorides and iodides in the phosphor-dispersed glass of the present invention. The phosphor-dispersed glass in which the phosphor particles are dispersed and encapsulated in the above-mentioned fluoride glass is advantageous in that, even when the phosphor particles are of a nitride phosphor which is deactivated in an oxygen atmosphere, the rate of decrease of the emission efficiency of the phosphor after encapsulation in the glass material relative to the emission efficiency of the phosphor before encapsulation in the glass material is 30% or lower.

Examples of the nitrogen phosphor are: red phosphors such as $(Ca,Sr)_2Si_5N_8:Eu^{2+}$ phosphor and $CaAlSiN_3:Eu^{2+}$ phosphor; yellow phosphors such as Ca-$\alpha$-Sialon:$Eu^{2+}$ phosphor; green phosphors such as $\beta$-Sialon:$Eu^{2+}$ phosphor, $(Sr,Ba)Si_2O_2N_2:Eu^{2+}$ phosphor and $Ba_3Si_6O_{12}N_2:Eu^{2+}$ phosphor; and blue phosphors such as $SrSi_9Al_{19}ON_{31}:Eu^{2+}$ phosphor.

In the phosphor-dispersed glass of the present invention, particles of an oxide phosphor can also suitably be used as the phosphor particles. Examples of the oxide phosphor are: yellow phosphors such as $(Y,Gd)_3Al_5O_{12}:Ce^{3+}$ phosphor, $Tb_3Al_5O_{12}:Ce^{3+}$ phosphor, $Lu_3Al_5O_{12}:Ce^{3+}$ phosphor and $(Sr,Ca,B2)_2SiO_4:Eu^{2+}$ phosphor; green phosphors such as $Y_3(Al,Ga)_5O_{12}:Ce^{3+}$ phosphor, $(Ba,Sr)_2SiO_4:Eu^{2+}$ phosphor; $CaSc_2O_4:Ce^{3+}$ phosphor, $BaMgAl_{10}O_{17}:Eu^{2+}$ phosphor, $Mn^{2+}$ phosphor and $SrAl_2O_4:Eu^{2+}$ phosphor; and red phosphors such as $(Sr,Ba)_3SiO_5:Eu^{2+}$ phosphor.

As is generally known, a fluorescence emission material is produced by adding a rare-earth element ion as a phosphor luminescence center into a fluoride glass material and reducing the rare-earth element ion. It is feasible, as a matter of course, to utilize the fluoride glass material of the present invention in the same manner as above.

It is also feasible to utilize the fluoride glass material of the present invention as an encapsulant capable of transmitting therethrough not only a visible light but also an infrared light as the fluoride glass material is transparent in the wavelength range from ultraviolet region to infrared region (wavelength: 7 to 8 $\mu$m).

The phosphor-dispersed glass of the present invention is preferably utilized for production of a white LED device with high color-rendering properties.

The phosphor-dispersed glass of the present invention is produced by mixing the phosphor particles in a powder of the above fluoride glass material and sintering the resulting glass powder mixture. For mixing of the phosphor particles in the glass material powder, the particle size of the glass material powder is preferably as close as the size of the phosphor particles. In general, the particle size of the glass material powder is of the order of 1 to 100 $\mu$m. The glass material powder is formed by e.g. pulverizing the fluoride glass material to a desired size. The pulverization is preferably performed in an inert atmosphere of argon gas, nitrogen gas or the like so as to protect the fluoride glass material from surface oxidation. Further, the pulverization is preferably performed by the use of a jet mill pulverizer, which causes less contamination during process step, although it is feasible to perform the pulverization by the use of a mortar or a ball mill.

The phosphor particles are preferably mixed in an amount of 0.01 to 30 mass% with the glass material powder. When the amount of the phosphor particles mixed exceeds 30 mass%, it may become difficult to sinter the glass material or may become impossible to efficiently irradiate the phosphor particles with excitation light. When the amount of the phosphor particles mixed is less than 0.01 mass%, it may become difficult to obtain sufficient emission from the phosphor particles.

In Examples of the present specification, the pulverization was performed such that the median diameter of the glass powder fell within the above range of 1 to 100 $\mu$m. The median diameter can be measured by laser diffraction and scattering with the use of e.g. Microtrac MT3000 available from NIKKISO Co., Ltd. More specifically, the median diameter d50 can be determined as a particle size at 50% accumulation in a particle size distribution as measured by dispersing the glass powder in a solvent and irradiating the resulting dispersion with a laser light.

It is feasible to produce the phosphor-dispersed glass by press-molding the glass powder mixture, in which the phosphor particles are mixed in the glass powder at a desired ratio as mentioned above, into a pellet and sintering the pellet by heating.

The sintering is preferably performed in an inert atmosphere of nitrogen gas, argon gas or the like so as to prevent surface oxidation of the fluoride gas material and surface oxidation of the phosphor particles although it is feasible to perform the sintering in an air atmosphere.

Further, the sintering is preferably performed in a temperature range of $\pm$ 100°C, more preferably $\pm$ 50°C, of a softening temperature of the glass material. The glass material is difficult to flow so that it is hard to obtain the coarse sintered glass when the sintering temperature is lower by 10°C or more than the glass softening temperature. When the sintering temperature is higher by 10°C or more than the glass softening temperature, there may occur deactivation of the phosphor particles. Such high-temperature sintering is not suitable for the object of the present invention.

It is accordingly a preferred embodiment of the present invention to produce the phosphor-dispersed glass by mixing the phosphor particles in the powder of the above fluoride glass material and sintering the resulting glass powder mixture, wherein the sintering is performed in an atmosphere whose oxygen concentration is 5000 ppm or lower.

In order to prevent the entry of bubbles in the glass powder mixture, it is preferable to perform the sintering under a reduced pressure or to apply a pressure to the mixture during the sintering.

The phosphor-dispersed glass of the present invention may be produced by mixing a plurality of glass powders of different compositions including the powder of the fluoride glass material. For low-temperature sintering, it is advantageous and preferable to use a glass material having a low softening temperature as the low-softening glass material flows in clearances between the fluoride glass material powder and the phosphor particles and serves as a flux. A crystal powder may be mixed with the powder of the fluoride glass material as long as the crystal powder becomes transparent within the wavelength range for use of the phosphor-dispersed glass of the present invention.

The phosphor-dispersed glass, which is produced by molding the mixed glass powder into a pellet and sintering the pellet as mentioned above, is commonly used as a bulk body. The phosphor-dispersed glass can alternatively be used as a phosphor layer by sintering the glass powder mixture on a radiation board of AlN, CaN etc., a metal plate of Al, Cu etc., a dielectric multilayer film or a reflection film of Ag, Au etc. In the case of using the phosphor-dispersed glass as the phosphor layer, a filler such as low-thermal-expansion ceramic material may be contained in the phosphor-dispersed glass in view of the difference in thermal expansion coefficient between the phosphor-dispersed glass and the substrate or film.

Examples

The present invention will be described in more detail below by way of Examples and Comparative Example.

[Example 1]

Fluoride glass materials were obtained by using and mixing raw fluoride compounds at respective mol% as shown in Nos. 1 to 9 of TABLE 1, placing the raw glass compound mixture in a crucible of glassy carbon, melting the raw glass compound mixture at 980°C for 1 hour in an atmosphere of 99% nitrogen and 1% chloride as a partial pressure component, and then, rapidly cooling the glass melt.

The softening temperature (Ts) of the respective fluoride glass materials was measured. The measurement of the softening temperature (Ts) was done with the use of a wide-range viscometer (WRVM-313 available from OPT Corporation). Each of the obtained fluoride glass materials had a softening temperature (Ts) of 500°C or lower.

Subsequently, each of the obtained fluoride glass materials was pulverized into a powder of glass particles with a median diameter d50 of 10 $\mu$m, following by adding thereto 5 mass% of particles of nitrogen phosphor ($CaAlSiN_3$:$Eu^{2+}$ luminescence center wavelength: 630 nm). The resulting composition was mixed sufficiently and press-molded into a pellet with a diameter of 12 mm and a thickness of 2 mm. The pellet was sintered by heating in a nitrogen atmosphere for 1 minute at a softening temperature of the glass composition. The thus-formed samples were orange in color.

All of the above process steps were performed at an oxygen concentration of 5000 ppm or lower. When the oxygen concentration was higher than 5000 ppm, the color of the sintered sample was changed to gray; and the emission efficiency of the phosphor particles was deteriorated.

[Comparative Example 1]

A glass material was obtained by mixing raw oxide compounds at a composition ratio of $B_2O_3$: 43, ZnO: 20 and $Bi_2O_3$: 37 (each in terms of mol%), placing the raw glass compound mixture in a crucible of platinum, melting the raw glass compound mixture in the air for 1 hour at 1100°C, casting the glass melt on a carbon mold, and then, rapidly cooling the glass melt. The obtained glass material had a softening temperature (Ts) of 445°C.

Subsequently, the obtained glass material was pulverized into a powder of glass particles with a median diameter d50 of 10 $\mu$m, following by adding thereto 5 mass% of particles of nitrogen phosphor ($CaAlSiN_3$:$Eu^{2+}$, luminescence center wavelength: 630 nm). The resulting composition was mixed sufficiently and press-molded into a pellet with a diameter of 12 mm and a thickness of 2 mm. The pellet was sintered by heating in the air for 30 minutes at 445°C. The thus-formed sample was gray in color and was not suitable as a phosphor-dispersed glass.

[Comparative Example 2]

The production of fluoride glass materials was performed in the same manner as in Example 1 except for using and mixing raw fluoride compounds at respective mol% as shown in Nos. 10 to 15 of TABLE 1. However, all of the glass compositions were not vitrified.

TABLE 1

| No. | AlF$_3$ | ZrF$_4$ | HfF$_4$ | BaF$_2$ | SrF$_2$ | CaF$_2$ | MgF$_2$ |
|---|---|---|---|---|---|---|---|
| 1 | 3 | 53 | | 22 | | | |
| 2 | 15 | | 32 | 16 | 7 | 7.7 | 1.5 |
| 3 | 20 | 30 | | 13 | 15 | 10 | 2 |
| 4 | 30 | 10 | | 11 | 13 | 20 | 3 |
| 5 | 30 | | 10 | 11 | 13 | 20 | 3 |
| 6 | 35 | | | 10 | 10 | 20 | 10 |
| 7 | 34 | 1 | | 10 | 10 | 20 | 10 |
| 8 | 20 | 30 | | 13 | 15 | 10 | 2 |
| 9 | 43 | | | 20 | | 20 | |
| 10 | 11 | 62 | | 14 | | | |
| 11 | 50 | | | | 21 | | 15 |
| 12 | 45 | | | | 20 | | 10 |
| 13 | 20 | | | 20 | 20 | 20 | 18 |
| 14 | | 57 | | 37 | | | |
| 15 | 15 | 35 | | 40 | | | |

TABLE 1 (continued)

| No. | YF$_3$ | LaF$_3$ | NaF | Ts | $\eta_{int}/\eta_{ext}$ | Remarks |
|---|---|---|---|---|---|---|
| 1 | 2 | 3 | 17 | 322 | 78%/68% | |
| 2 | 5.6 | 2.2 | 13 | 390 | 73%/66% | |
| 3 | 2 | | 8 | 390 | 72%/65% | |
| 4 | 9 | | 4 | 462 | 67%/60% | |
| 5 | 9 | | 4 | 465 | 61%/55% | |
| 6 | 15 | | | 497 | 69%/64% | |
| 7 | 15 | | | 490 | 65%/59% | |
| 8 | 2 | | 8 | 390 | 72%/65% | |
| 9 | 17 | | | 499 | 67%/61% | |
| 10 | | 5 | 8 | — | — | not vitrified |
| 11 | 14 | | | — | — | not vitrified |
| 12 | 25 | | | — | — | not vitrified |
| 13 | 2 | | | — | — | not vitrified |
| 14 | | 5 | 1 | — | — | not vitrified |
| 15 | | | 10 | — | — | not vitrified |

[Evaluation of Quantum Efficiencies]

The internal quantum efficiency ($\eta_{int}$) and external quantum efficiency ($\eta_{out}$) of the samples No. 1 to No. 9 were evaluated. The evaluation results are shown in TABLE 1. The evaluation of the internal and external quantum efficiencies was carried by measuring excitation and fluorescence spectra of each sample by the use of a spectrophotofluorometer (FP6500 available from JASCO Corporation) with an integrating sphere (ILF-533 available from JASCO Corporation). The internal quantum efficiency and the external quantum efficiency were determined as C/A and C/B, respectively, with the proviso that, in the excitation and fluorescence spectra, A was the integrated intensity of excitation light incident to the integrating sphere; B was the integrated intensity of excitation light absorbed by the sample; and C was the integrated intensity of fluorescence emitted from the sample.

The internal quantum efficiency of the nitride phosphor before encapsulation in the glass material was measured to be 80%. By contrast, the internal quantum efficiencies of the respective phosphor-dispersed glasses were 61 to 78% as shown in TABLE 1. Further, the internal quantum efficiency of the glass sample of Comparative Example 1 was measured to be 10%. It has been shown by these results that it is possible for the fluoride glass material of the present invention to suppress deactivation of the nitride phosphor.

[Measurement of Fluorescence Spectrum]

The fluorescence spectrum of the sample No.6 was measured at an excitation wavelength of 450 nm. The measured fluorescence spectrum is shown in FIG. 1. The measurement of the fluorescence spectrum was done with the use of a spectrophotofluorometer (FP6500 available from JASCO Corporation). In the fluorescence spectrum, there was a peak at a wavelength of 450 nm attributed to an excitation light absorbed by the phosphor. The emission of the sample No. 6 showed an emission in the vicinity of 630 nm. The intensity of emission of Comparative Example 1 was significantly lower.

[Chemical Durability Test]

The samples of No. 1 and No. 4 to No. 6 was subjected weather resistance test according to JIS 3254-1995 "Testing Method for Chemical Durabilities of Fluoride Glasses". More specifically, each of the fluoride glass samples was tested by immersing the sample in water at 30°C, measuring the mass decrease of the sample and determining the elusion rate from the measured mass decrease by the following equation:

$$Q \ [\mathrm{g/cm^2 \cdot d}] = (W_0 - W_1)/(t \times s)$$

where $W_0$ was the mass [g] of the sample before the test; $W_1$ was the mass [g] of the sample after the test; $t$ was the elution time [d]; and $s$ was the surface area [cm$^2$] of the sample.

As a result of the measurement test, the elution rates of the samples No. 1 and No. 4 to No. 6 were $3.61 \times 10^{-2}$, $4.86 \times 10^{-3}$, $6.08 \times 10^{-3}$ and $7.29 \times 10^{-4}$, respectively. The samples No. 4 to No. 6 had better water resistance than that of the sample No. 1 in which 53 mol% of $ZrF_4$ was contained.

[Example 2]

A sample was formed in the same manner as in Example 1 by using the same fluoride glass material as the sample No. 6 of TABLE 1 and using YAG-Ce phosphor in place of the nitride phosphor.

The internal quantum efficiency of the YAG-Ce phosphor before encapsulation in the glass material was measured to be 83%. By contrast, the internal quantum efficiencies of the glass sample of Example 2 was 74%. It has been shown by these results that: it is possible for the fluoride glass material of the present invention to suppress deactivation of the phosphor; and the fluoride glass material of the present invention is usable for encapsulation of an oxide phosphor.

**Claims**

1. A phosphor-dispersed glass comprising:

   phosphor particles; and
   a phosphor encapsulant,
   wherein the phosphor encapsulant is a fluoride glass material containing 1 to 45 mol% of $AlF_3$, 30 to 60 mol% of a sum of a fluoride of Hf and a fluoride of Zr, 20 to 65 mol% of alkaline earth fluorides in total, 2 to 25 mol% in total of at least one fluoride of element selected from the group consisting of Y, La, Gd and Lu and 0 to 20 mol% in total of at least one fluoride of element selected from the group consisting of Na, Li and K.

2. The phosphor-dispersed glass according to claim 1, wherein the fluoride glass material has a softening temperature of 250 to 400°C.

3. A phosphor-dispersed glass comprising:

   phosphor particles; and
   a phosphor encapsulant,
   wherein the phosphor encapsulant is a fluoride glass material containing 20 to 45 mol% of $AlF_3$, 0 to 30 mol% of a sum of a fluoride of Hf and a fluoride of Zr, 35 to 65 mol% of alkaline earth fluorides in total, 2 to 25 mol% in total of at least one fluoride of element selected from the group consisting of Y, La, Gd and Lu and 0 to 9 mol% in total of at least one fluoride of element selected from the group consisting of Na, Li and K.

4. The phosphor-dispersed glass according to claim 3, wherein the fluoride glass material has a softening temperature of 380 to 500°C.

5. The phosphor-dispersed glass according to any one of claims 1 to 4, wherein the phosphor particles are of at least one selected from the group consisting of nitrides, sulfides, selenium compounds, tellurium compounds, chlorides and iodides.

6. The phosphor-dispersed glass according to any one of claims 1 to 4, wherein the phosphor particles are of an oxide.

7. A white LED device comprising the phosphor-dispersed glass according to any one of claims 1 to 6.

8. A method for producing a phosphor-dispersed glass, comprising:

mixing phosphor particles with a powder of the fluoride glass material according to any one of claims 1 to 4 and thereby forming a mixture; and
sintering the mixture,
wherein the sintering is performed in an atmosphere whose oxygen concentration is 5000 ppm or lower.

# FIG.1

## INTERNATIONAL SEARCH REPORT

| International application No. |
|---|
| PCT/JP2014/067606 |

**A. CLASSIFICATION OF SUBJECT MATTER**
*C03C4/12*(2006.01)i, *C03C3/32*(2006.01)i, *H01L33/50*(2010.01)i

According to International Patent Classification (IPC) or to both national classification and IPC

**B. FIELDS SEARCHED**

Minimum documentation searched (classification system followed by classification symbols)
C03C4/12, C03C3/32, H01L33/50

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2006-202962 A (Toyoda Gosei Co., Ltd.), 03 August 2006 (03.08.2006), claims 1, 7; paragraphs [0033] to [0037] & US 2006-171152 A1 | 1–8 |
| A | JP 2008-60428 A (Nichia Chemical Industries, Ltd.), 13 March 2008 (13.03.2008), claims 1, 9, 10, 23; paragraphs [0041], [0080] to [0096] (Family: none) | 1–8 |
| A | JP 2006-248800 A (Central Glass Co., Ltd.), 21 September 2006 (21.09.2006), claim 1; examples (Family: none) | 1–8 |

| ☒ Further documents are listed in the continuation of Box C. | ☐ See patent family annex. |
|---|---|

\*    Special categories of cited documents:
"A"   document defining the general state of the art which is not considered    to be of particular relevance
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search | Date of mailing of the international search report |
|---|---|
| 28 August, 2014 (28.08.14) | 09 September, 2014 (09.09.14) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
| --- |
| PCT/JP2014/067606 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2008-201610 A  (Central Glass Co., Ltd.),<br>04 September 2008 (04.09.2008),<br>claims 1, 4; examples<br>& WO 2008/102488 A1 | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5045432 B
- JP 2008019109 A
- JP 2012178395 A
- JP 4492378 B
- JP 2010280797 A
- JP 2006248800 A

**Non-patent literature cited in the description**

- **YEH CW et al.** Origin of thermal degradation of Sr(2-x)Si5N8:Eu(x) phosphors in air for light-emitting diodes. *J. Am. Chem. Soc.,* 2012, vol. 134, 14108-14117